# EUROPEAN PATENT SPECIFICATION

(11) **EP 2 802 064 B1**
(45) Date of publication and mention of the grant of the patent: **09.11.2016**
(21) Application number: 13824822.4
(22) Date of filing: 09.04.2013
(51) Int. Cl.: H02M 1/00, H01L 25/16, H01L 23/495

(54) **POWER MODULE AND ENCAPSULATION METHOD THEREOF**
LEISTUNGSMODUL UND VERKAPSELUNGSVERFAHREN DAFÜR
MODULE D'ALIMENTATION ET SON PROCÉDÉ D'ENCAPSULATION

(30) Priority: 30.07.2012 CN 201210268316
(43) Date of publication of application: 12.11.2014
(60) Divisional application: 16184829.6
(73) Proprietor: Huawei Technologies Co., Ltd., Longgang District Shenzhen, Guangdong 518129 (CN)
(72) Inventor: DUAN, Zhihua, Shenzhen Guangdong 518129 (CN); HOU, Zhaozheng, Shenzhen Guangdong 518129 (CN)
(74) Representative: Thun, Clemens
(86) International application number: PCT/CN2013/073950
(87) International publication number: WO 2014/019384

(56) References cited:
- EP-A1- 1 091 404
- WO-A2-2008/011459
- CN-A- 101 383 342
- CN-A- 102 088 241
- CN-A- 102 171 825
- CN-A- 102 171 825
- CN-A- 102 569 291
- CN-A- 102 790 513
- JP-A- 2008 301 594
- US-A- 5 839 184
- US-A1- 2007 074 386

## Description

### TECHNICAL FIELD

Embodiments of the present invention relate to electronic technologies, and in particular, to a power supply module and a method for packaging a power supply module.

### BACKGROUND

Main components of a power supply module include a power switch, an integrated circuit (Integrated Circuit, IC for short), and passive devices. The passive devices include a magnetic device, a resistor, and a capacitor. The magnetic device may be an inductor. A commonly used power switch is a metal-oxide semiconductor field- effect transistor (MOSFET Metallic Oxide Semiconductor Field Effect Transistor, MOSFET for short) or an insulated gate bipolar transistor (Insulated Gate Bipolar Transistor, IGBT for short), and the IC may be a driver chip, a PWM control chip, or a combination of a driver chip and a PWM control chip. Currently, power supply manufacturers and semiconductor manufacturers, in packaging and integration solutions for power supply modules, mostly use a structure into which a MOSFET, an IC, and passive devices are integrated. A PCB or another lead frame uses a gold wire or copper wire bonding interconnection manner. As a switch, the MOSFET is controlled or driven by the IC to perform pulse width modulation on an input power supply, and after filtering is performed by an inductor and a capacitor, a voltage required by a load is output.

For example, EP 2 482 312 A2 refers to a power supply module and a packaging and integrating method thereof. The power supply module includes a lead frame, a passive element, an integrated circuit IC, and a power switch Metallic Oxide Semiconductor Field Effect Transistor MOSFET. The passive element is soldered onto the lead frame by using the surface mount technology. The IC is a flip chip and is mounted and soldered onto the lead frame.

Further, US 5,839,184 refers to a method for creating an inductor in the package for an integrated circuit. The inductor is formed by utilizing one or more of the bond leads as the core of the inductor and by winding a series of coils about the core in connection either with the bond pads of the integrated circuit itself or to other bond leads for connection outside the integrated circuit chip.

Further, WO 2008/011459 A2 refers to an electronic device with one or more semiconductor chips having an inductor assembled on or under the chips. The inductor includes a ferromagnetic body and a wire wrapped around the body to form at least a portion of a loop. The wire ends are connected to the chips. The assembly is attached to a substrate, which may be a leadframe. The device may be encapsulated in molding compound so that the inductor can double as a heat spreader, enhancing the thermal device characteristics.

Further, US 2007/0074386 A1 refers to a method of forming a power module located on a conductive substrate by providing power conversion circuitry. The method of providing the power conversion circuitry includes forming a magnetic device by placing a magnetic core proximate a conductive substrate with a surface thereof facing a conductive substrate, and placing a conductive clip proximate a surface of the magnetic core. The method of forming the magnetic device also includes electrically coupling ends of the conductive clip to the conductive substrate to cooperatively form a winding therewith about the magnetic core. The method of providing the power conversion circuitry also includes providing at least one switch on the conductive substrate. The method of forming the power module also includes depositing an encapsulant about the power conversion circuitry.

In addition, EP 1 091 404 A1 refers to a lead frame for use in packaging a circuit having a discrete component, and a method of manufacture thereof. In one embodiment, the lead frame includes a lead support structure and a plurality of severable leads that are coupled to the lead support structure. The plurality of severable leads extend inward from the lead support structure to predetermined locations corresponding to terminals of the discrete component.

Currently, a magnetic device in a power supply module is generally a surface mount magnetic device or a winding magnetic device including a magnetic core material. The surface mount magnetic device has a small inductance and cannot meet requirements on power density and power supply efficiency, so that reliability of the power supply module deteriorates. An inductance of the winding magnetic device including the magnetic core material is large; however, a winding magnetic device that has been packaged is used in the power supply module, leading to a high risk of welding joint cracking, a high failure probability, and low reliability.

### SUMMARY

Embodiments of the present invention provide a power supply module and a method for packaging a power supply module, so as to lower a failure probability of a winding magnetic device in the power supply module and improve reliability of the power supply module.

According to one aspect, an embodiment of the present invention provides a power supply module, including:
a lead frame, an integrated circuit, passive devices, and two semiconductor bare chips, where
at least one magnetic device in the passive devices is a discrete magnetic device obtained by assembling a magnetic core and an electrical winding; and
   one end of the electrical winding is electrically connected to the lead frame, so that the one end of the electrical winding is electrically connected to the integrated circuit and the passive devices except all magnetic devices by means of the lead frame, wherein a source of one of the two semiconductor bare chips is electrically connected to a gate of the other semiconductor bare chip; and the other end of the electrical winding is electrically connected to the source of the one semiconductor bare chip directly, and the other end of the electrical winding is further electrically connected to the gate of the other semiconductor bare chip directly.

According to another aspect, an embodiment of the present invention further provides a method for packaging a power supply module, including:
surface-mounting two semiconductor bare chips, passive devices except a magnetic device, and an integrated circuit on a lead frame;
surface-mounting, on the lead frame, a discrete magnetic device obtained by assembling a magnetic core and an electrical winding;
electrically connecting a source of one of the two semiconductor bare chips to a gate of the other semiconductor bare chip and electrically connecting one end of the electrical winding to the lead frame, and electrically connecting the other end of the electrical winding to the source of the one semiconductor bare chip directly, and further electrically connecting the other end of the electrical winding to the gate of the other semiconductor bare chip directly; and
after plastic packaging is performed on the lead frame on which components are surface-mounted, cutting the lead frame to obtain a single power supply module.

In the technical solutions of the embodiments of the present invention, at least one magnetic device in a power supply module is a discrete magnetic device obtained by assembling a magnetic core and an electrical winding in a process of packaging the power supply module instead of a packaged magnetic device independently packaged. One end of the electrical winding of the discrete magnetic device is electrically connected to a semiconductor bare chip directly and does not need to be electrically connected to the semiconductor bare chip by means of a lead frame. The magnetic device in the power supply module provided in the embodiments of the present invention is a discrete magnetic device, which reduces mechanical stress of an electrical connection between the magnetic device and the lead frame, improves heat dissipation performance, and lowers a failure probability of the magnetic device. Meanwhile, the one end of the electrical winding of the discrete magnetic device is electrically connected to the semiconductor bare chip directly, which further reduces connection wires between internal devices of the power supply module, lowers impedance, and improves efficiency of the power supply module.

### BRIEF DESCRIPTION OF DRAWINGS

FIG. 1 is a schematic structural diagram of a power supply module according to an embodiment of the present invention;
FIG. 2 is a schematic structural diagram of another power supply module according to an embodiment of the present invention;
FIG. 3 is a flowchart of a method for packaging a power supply module according to an embodiment of the present invention; and
FIG. 4 is a flowchart of step 32 in FIG. 3.

### DESCRIPTION OF EMBODIMENTS

A power supply module provided in an embodiment of the present invention includes a lead frame, an integrated circuit, passive devices, and at least one semiconductor bare chip. The semiconductor bare chip may be a MOSFET, or an IGBT, or a combination of an IGBT and a MOSFET. The power supply module provided in the embodiment of the present invention may be mounted on a PCB motherboard by means of the lead frame.

At least one magnetic device in the passive devices is a discrete magnetic device including a magnetic core and an electrical winding. The power supply module provided in the embodiment of the present invention has at least one discrete magnetic device, and the discrete magnetic device is a magnetic device obtained by assembling a magnetic core and an electrical winding in a process of packaging the power supply module, is not exteriorly packaged, and is not an independently packaged magnetic device. A material of the electrical winding may be metal, such as gold, aluminum, or copper, and may be of any proper width and thickness.

One end of the electrical winding of the discrete magnetic device is electrically connected to the lead frame, so that the one end of the electrical winding is electrically connected to the integrated circuit and the passive devices except all magnetic devices by means of the lead frame. The other end of the electrical winding of the discrete magnetic device is electrically connected to the semiconductor bare chip directly and does not need to be electrically connected to the semiconductor bare chip by means of the lead frame.

The electrical winding may be electrically connected to the lead frame and the semiconductor bare chip in a welding manner, a bonding manner, or an adhering manner with a conductive adhesive, which is not limited to these three manners. Preferably, the electrical winding is an aluminum strip; and the one end of the electrical winding is electrically connected to the lead frame in a bonding manner or an adhering manner, and the other end of the electrical winding is electrically connected to the semiconductor bare chip directly in a bonding manner or an adhering manner. Electrical connection is performed in a bonding or adhering manner, which can reduce connection wires between internal devices of the power supply module, reduce parasitic parameters, lower losses, and improve power supply efficiency.

The integrated circuit is connected to the semiconductor bare chip and the passive devices by means of the lead frame.

Further, the power supply module may include two semiconductor bare chips, and a source of one semiconductor bare chip is electrically connected to a gate of the other semiconductor bare chip; and the other end of the electrical winding is electrically connected to the source of the one semiconductor bare chip directly, and the other end of the electrical winding is further electrically connected to the gate of the other semiconductor bare chip directly.

In the power supply module provided in this embodiment, at least one magnetic device is a discrete magnetic device obtained by assembling a magnetic core and an electrical winding in a process of packaging the power supply module instead of a packaged magnetic device independently packaged. One end of the electrical winding of the discrete magnetic device is electrically connected to a semiconductor bare chip directly and does not need to be electrically connected to the semiconductor bare chip by means of a lead frame. The magnetic device in the power supply module provided in the embodiment of the present invention is a discrete magnetic device, which reduces mechanical stress of an electrical connection between the magnetic device and the lead frame, improves heat dissipation performance, and lowers a failure probability of the magnetic device. Meanwhile, the one end of the electrical winding of the discrete magnetic device is electrically connected to the semiconductor bare chip directly, which further reduces connection wires between internal devices of the power supply module, lowers impedance, and improves efficiency of the power supply module.

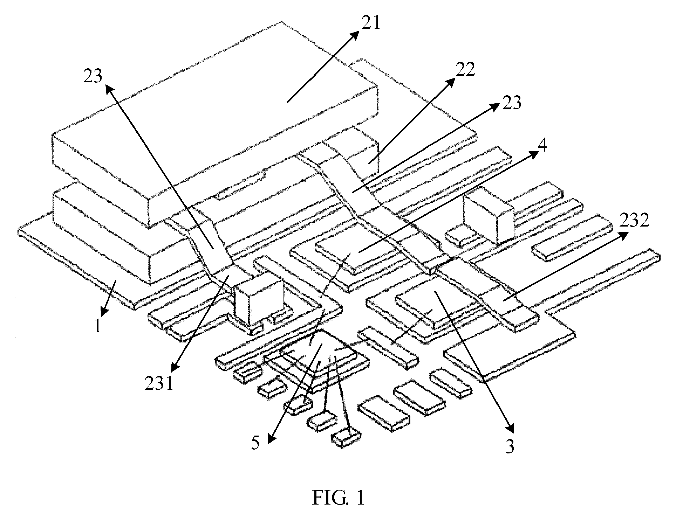

FIG. 1 is a schematic structural diagram of a power supply module according to an embodiment of the present invention. The power supply module provided in this embodiment includes a magnetic device, and the magnetic device is a discrete magnetic device obtained by assembling two half magnetic cores and an electrical winding. A magnetic core of the discrete magnetic device includes two half magnetic cores disposed in a coupling manner, and the electrical winding is disposed in space between the two coupled half magnetic cores. Preferably, a protruding part such as a protruding cylinder is disposed in a center of a surface of each half magnetic core, and the two half magnetic cores are disposed in a coupling manner by means of the central protruding parts.

As shown in FIG. 1, the discrete magnetic device in this embodiment includes a half magnetic core 21, a half magnetic core 22, and an electrical winding 23. A protruding part is disposed in a center of each of the half magnetic core 21 and the half magnetic core 22, and the half magnetic core 21 and the half magnetic core 22 are disposed in a coupling manner by means of the central protruding parts. The electrical winding 23 is disposed in space between the half magnetic core 21 and the half magnetic core 22 that are coupled together. Therefore, the electrical winding 23 is wrapped by the half magnetic core 21 and the half magnetic core 22. One end 231 of the electrical winding 23 is electrically connected to a lead frame 1, that is, the one end 231 of the electrical winding 23 is electrically connected to an integrated circuit 5 and passive devices except the magnetic device by means of the lead frame 1.

As shown in FIG. 1, the power supply module includes two cascaded semiconductor bare chips, and a source of a semiconductor bare chip 3 is electrically connected to a gate of a semiconductor bare chip 4. The other end 232 of the electrical winding 23 is electrically connected to the semiconductor bare chip 3 and the semiconductor bare chip 4 directly, that is, the other end 232 of the electrical winding 23 is electrically connected to the source of the semiconductor bare chip 3 directly, and is further electrically connected to the gate of the semiconductor bare chip 4 directly. The semiconductor bare chip 3 and the semiconductor bare chip 4 are further electrically connected to the integrated circuit 5 by means of the lead frame.

The discrete magnetic device in this embodiment is not manufactured independently, but obtained by assembly in a module packaging process. A half magnetic core with a central protruding part is first mounted on the lead frame, and a surface, of the half magnetic core, without a protruding part is disposed on the lead frame, and then the electrical winding is laid on the half magnetic core. Then, the one end of the electrical winding is connected to the lead frame, and the other end is electrically connected to the semiconductor bare chip directly. Then, a central protruding part of the other half magnetic core is coupled to the protruding part of the half magnetic core that has been mounted, to close a magnetic circuit of the electrical winding.

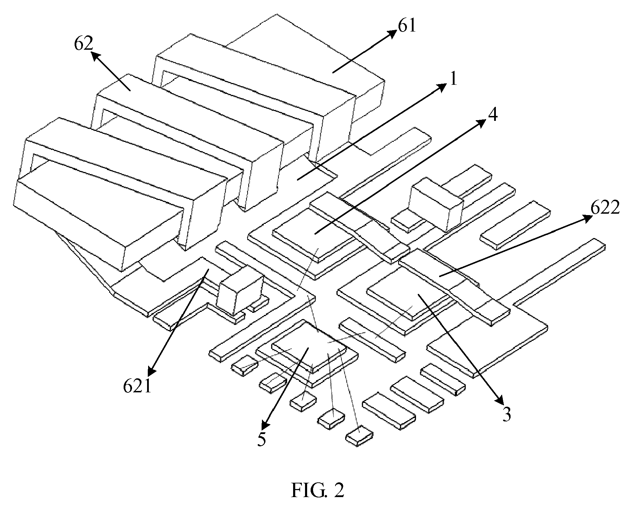

FIG. 2 is a schematic structural diagram of another power supply module according to an embodiment of the present invention. In the power supply module provided in this embodiment, a discrete magnetic device is obtained by assembling a magnetic core and an electrical winding, and the electrical winding is wound around an exterior of the magnetic core.

As shown in FIG. 2, an electrical winding 62 is wound around an exterior of a magnetic core 61, and the magnetic core wound with the electrical winding 62 forms a discrete magnetic device by assembly. One end 621 of the electrical winding 62 is electrically connected to a lead frame 1, that is, the one end 621 of the electrical winding 62 is electrically connected to an integrated circuit 5 and passive devices except the magnetic device by means of the lead frame 1.

As shown in FIG. 2, the power supply module includes two cascaded semiconductor bare chips, and a source of a semiconductor bare chip 3 is electrically connected to a gate of a semiconductor bare chip 4. The other end 622 of the electrical winding 62 is electrically connected to the semiconductor bare chip 3 and the semiconductor bare chip 4 directly, that is, the other end 622 of the electrical winding 62 is electrically connected to the source of the semiconductor bare chip 3 directly, and is further electrically connected to the gate of the semiconductor bare chip 4 directly. The other end 622 of the electrical winding 62 is connected to a top portion of a semiconductor bare chip, and a bottom portion of the semiconductor bare chip is connected to the lead frame by using soldering tin, and is connected to an electrical winding at a bottom portion of the magnetic core 61. The discrete magnetic device in this embodiment is not manufactured independently, but obtained by assembly in a module packaging process. A magnetic core of which an exterior is wound with the electrical winding is first mounted on the lead frame, and then one exposed end of the electrical winding is connected to the lead frame, and the other exposed end is electrically connected to the semiconductor bare chip directly.

Preferably, in the embodiments corresponding to FIG. 1 and FIG. 2, the electrical winding may be a metal strip-shaped wire with one or more turns. When the electrical winding has multiple turns, the turns are connected to each other in series or in parallel, and one end of each turn is electrically connected to the lead frame in a mechanical press-fit manner.

Preferably, in the embodiments corresponding to FIG. 1 and FIG. 2, the electrical winding is an aluminum strip; and the one end of the electrical winding is electrically connected to the lead frame in a bonding manner or an adhering manner, and the other end of the electrical winding is electrically connected to the semiconductor bare chip in a bonding manner or an adhering manner directly.

Preferably, in the embodiments corresponding to FIG. 1 and FIG. 2, the semiconductor bare chip is a vertical semiconductor device.

In the foregoing embodiments, a lead frame may be obtained by using a stamping technique known in the art, or may be a predetermined graph obtained by using an etched conductive plate, or may be obtained with reference to the stamping technique and an etching technique. Therefore, a structure of the lead frame in the embodiments may be a continuous or discontinuous metal structure. The structure of the lead frame includes any proper material, may be of any proper form and thickness, and further includes a metal coating layer on the lead frame, such as a silver coating layer, a nickel-gold coating layer, or a nickel-palladium-gold coating layer. Exemplarily, a body material of the lead frame includes copper, aluminum and aluminum alloy, ferronickel, and the like. The lead frame is initially one of many units of a lead frame array that are connected together by using a tie rod. In a technique for packaging a manufactured semiconductor die, the lead frame array may be cut or punched so that packaging is performed separately. In addition, the structure of the lead frame may have multiple die pad areas in which a die attach pad, DAP may be formed, and a lead may be coplanar with or not coplanar with a surface of a die attach pad DAP.

In the foregoing embodiments, a module packaging material used for packaging the power supply module may include a proper material, such as a multifunctional cross-linked epoxy resin composite material. The module packaging material is softened from a fixed material cake form at a high temperature to a colloidal state in which solids and liquids coexist, transferred and injected into a mould to shape with a lead frame placed in the mould, and solidified and shaped after a cross-linking reaction.

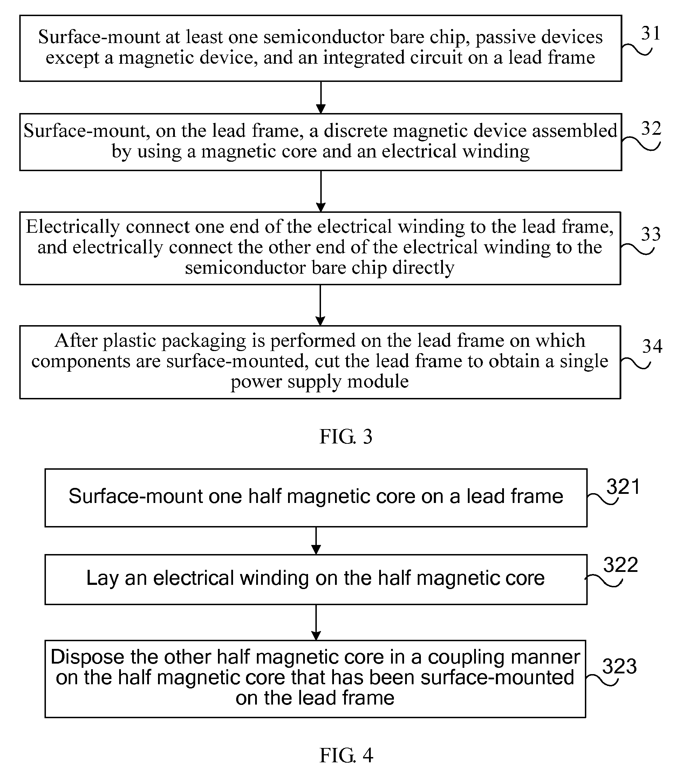

FIG. 3 is a flowchart of a method for packaging a power supply module according to an embodiment of the present invention. The packaging method provided in this embodiment includes: Step 31: Surface-mount at least one semiconductor bare chip, passive devices except a magnetic device, and an integrated circuit on a lead frame.

Step 32: Surface-mount, on the lead frame, a discrete magnetic device obtained by assembling a magnetic core and an electrical winding.

The discrete magnetic device is a magnetic device obtained by assembling the magnetic core and the electrical winding in a process of packaging the power supply module, is not exteriorly packaged, and is not an independently packaged magnetic device. A material of the foregoing electrical winding may be metal, such as gold, aluminum, or copper, and may be of any proper width and thickness.

Step 33: Electrically connect one end of the electrical winding to the lead frame, and electrically connect the other end of the electrical winding to the semiconductor bare chip directly.

One end of the electrical winding of the discrete magnetic device is electrically connected to the lead frame, so that the one end of the electrical winding is electrically connected to the integrated circuit and the passive devices except the magnetic device by means of the lead frame. The other end of the electrical winding of the discrete magnetic device is electrically connected to the semiconductor bare chip directly and does not need to be electrically connected to the semiconductor bare chip by means of the lead frame.

The electrical winding may be electrically connected to the lead frame and the semiconductor bare chip in a welding manner, a bonding manner, or an adhering manner with a conductive adhesive, which is not limited to these three manners. Preferably, the electrical winding is an aluminum strip; and the one end of the electrical winding is electrically connected to the lead frame in a bonding manner or an adhering manner, and the other end of the electrical winding is electrically connected to the semiconductor bare chip directly in a bonding manner or an adhering manner. Electrical connection is performed in a bonding or adhering manner, which can reduce connection wires between internal devices of the power supply module, reduce parasitic parameters, lower losses, and improve power supply efficiency.

Step 34: After plastic packaging is performed on the lead frame on which components are surface-mounted, cut the lead frame to obtain a single power supply module.

Preferably, the electrical winding may be a metal strip-shaped wire with one or more turns. When the electrical winding has multiple turns, the turns are connected to each other in series or in parallel, and one end of each turn is electrically connected to the lead frame in a mechanical press-fit manner.

Preferably, the semiconductor bare chip is a vertical semiconductor device.

According to the packaging method provided in this embodiment, a discrete magnetic device obtained by assembling a magnetic core and an electrical winding is surface-mounted on a lead frame instead of surface-mounting an independently packaged magnetic device on the lead frame. One end of the electrical winding of the discrete magnetic device is electrically connected to a semiconductor bare chip directly rather than electrically connected to the semiconductor bare chip by means of the lead frame. The magnetic device in the power supply module provided in the embodiment of the present invention is a discrete magnetic device, which reduces mechanical stress of an electrical connection between the magnetic device and the lead frame and improves heat dissipation performance. Meanwhile, the one end of the electrical winding of the discrete magnetic device is electrically connected to the semiconductor bare chip directly, which further reduces connection wires between internal devices of the power supply module, lowers impedance, and improves efficiency of the power supply module.

FIG. 4 is a flowchart of step 32 in FIG. 3. In this embodiment, two half magnetic cores and the electrical winding are used to assemble the discrete magnetic device, and the packaging method provided in this embodiment is a method for packaging the power supply module provided in FIG. 1. As shown in FIG. 4, step 32 includes:
Step 321: Surface-mount one half magnetic core on the lead frame.
Step 322: Lay the electrical winding on the half magnetic core.
Step 323: Dispose the other half magnetic core in a coupling manner on the half magnetic core that has been surface-mounted on the lead frame.

A specific packaging process is as follows: preparing the lead frame, coating a solder paste on the lead frame, surface-mounting the semiconductor bare chip and the passive devices except the magnetic device on the lead frame, and performing washing; then, performing, on the lead frame, dispensing for mounting the integrated circuit and the half magnetic core, and surface-mounting the integrated circuit and the half magnetic core with a central protruding part on the lead frame, where the central protruding part of the half magnetic core faces upwards; filling the bottom portions of the integrated circuit and the half magnetic core with a filling adhesive and solidifying the bottom portions; laying the electrical winding on the half magnetic core, and respectively connecting the two ends of the electrical winding to the lead frame and the semiconductor bare chip in a bonding manner; connecting the integrated circuit and the semiconductor bare chip in a bonding manner; performing dispensing on the central protruding part of the half magnetic core that has been surface-mounted on the lead frame, and surface-mounting a central protruding part of the other half magnetic core on the central protruding part that has been surface-mounted on the lead frame, so that the two half magnetic cores are disposed in a coupling manner; and after plastic packaging is performed on the lead frame on which components are surface-mounted, cutting the lead frame to obtain a single power supply module.

In addition, the present invention may also use a magnetic core of which an exterior is wound with the electrical winding to assemble the discrete magnetic device. In this case, step 32 may be specifically surface-mounting, on the lead frame, the magnetic core of which the exterior is wound with the electrical winding. A specific packaging process is as follows: preparing the lead frame, coating a solder paste on the lead frame, surface-mounting the semiconductor bare chip and the passive devices except the magnetic device on the lead frame, and performing washing; then, performing, on the lead frame, dispensing for mounting the integrated circuit and the magnetic core, and surface-mounting the integrated circuit and the magnetic core of which the exterior is wound with the electrical winding on the lead frame; respectively connecting the two ends of the electrical winding to the lead frame and the semiconductor bare chip in a bonding manner; connecting the integrated circuit and the semiconductor bare chip in a bonding manner; and after plastic packaging is performed on the lead frame on which components are surface-mounted, cutting the lead frame to obtain a single power supply module. The foregoing packaging method may be a method for packaging the power supply module provided in FIG. 2.

According to the packaging method provided in the embodiments, a discrete magnetic device obtained by assembling a magnetic core and an electrical winding is surface-mounted on a lead frame instead of surface-mounting an independently packaged magnetic device on the lead frame. One end of the electrical winding of the discrete magnetic device is electrically connected to a semiconductor bare chip directly and does not need to be electrically connected to the semiconductor bare chip by means of the lead frame. The magnetic device in a power supply module provided in the embodiments of the present invention is a discrete magnetic device, which reduces mechanical stress of an electrical connection between the magnetic device and the lead frame and improves heat dissipation performance. Meanwhile, the one end of the electrical winding of the discrete magnetic device is electrically connected to the semiconductor bare chip directly, which further reduces connection wires between internal devices of the power supply module, lowers impedance, and improves efficiency of the power supply module.

## Claims

1. A power supply module, comprising a lead frame (1), an integrated circuit (5), passive devices, and two semiconductor bare chips (3,4), wherein:
at least one magnetic device in the passive devices is a discrete magnetic device obtained by assembling a magnetic core (21, 22) and an electrical winding (23); and
one end (231) of the electrical winding (23) is electrically connected to the lead frame (1), so that the one end (231) of the electrical winding (23) is electrically connected to the integrated circuit (5) and the passive devices except all magnetic devices by means of the lead frame (1), **characterized in that** a source of one of the two semiconductor bare chips is electrically connected to a gate of the other semiconductor bare chip; and the other end of the electrical winding (23) is electrically connected to the source of the one semiconductor bare chip directly, and the other end (232) of the electrical winding (23) is further electrically connected to the gate of the other semiconductor bare chip directly.

2. The power supply module according to claim 1, wherein the magnetic core comprises two half magnetic cores (21,22) disposed in a coupling manner, and the electrical winding is disposed in space between the two coupled half magnetic cores (21,22).

3. The power supply module according to claim 1, wherein the electrical winding (23) is wound around an exterior of the magnetic core (21,22).

4. The power supply module according to any one of claims 1 to 3, wherein the electrical winding (23) is an aluminum strip, the one end (231) of the electrical winding (23) is electrically connected to the lead frame (1) in a bonding manner or an adhering manner, and the other end (232) of the electrical winding (23) is electrically connected to the semiconductor bare chip in a bonding manner or an adhering manner directly.

5. The power supply module according to any one of claims 1 to 4, wherein the semiconductor bare chip is electrically connected to the lead frame (1) in an aluminum strip bonding manner or an adhering manner.

6. The power supply module according to any one of claims 1 to 5, wherein the electrical winding (23) has one or more turns.

7. The power supply module according to any one of claims 1 to 5, wherein when the electrical winding (23) has multiple turns, the turns are connected to each other in series or in parallel.

8. The power supply module according to any one of claims 1 to 7, wherein the semiconductor bare chip is a vertical semiconductor device.

9. A method for packaging a power supply module, comprising:
surface-mounting two semiconductor bare chips (3,4), passive devices except a magnetic device, and an integrated circuit (5) on a lead frame (1) (step 31);
surface-mounting, on the lead frame (1), a discrete magnetic device obtained by assembling a magnetic core (21, 22) and an electrical winding (23) (step 32);
electrically connecting a source of one of the two semiconductor bare chips to a gate of the other semiconductor bare chip and electrically connecting one end (231) of the electrical winding (23) to the lead frame (1), and electrically connecting the other end (232) of the electrical winding (23) to the source of the one semiconductor bare chip directly, and further electrically connecting the other end (232) of the electrical winding (23) to the gate of the other semiconductor bare chip directly (step 33); and
after plastic packaging is performed on the lead frame on which components are surface-mounted, cutting the lead frame (1) to obtain a single power supply module (step 34).

10. The method according to claim 9, wherein the surface-mounting, on the lead frame (1), a discrete magnetic device obtained by assembling a magnetic core (21, 22) and an electrical winding (23) comprises:
surface-mounting a half magnetic core (21) on the lead frame (1) (step 321);
laying the electrical winding (23) on the half magnetic core (21) (step 322); and
disposing another half magnetic core (22) in a coupling manner on the half magnetic core (21) that has been surface-mounted on the lead frame (1) (step 323).

11. The method according to claim 9, wherein the surface-mounting, on the lead frame (1), a discrete magnetic device obtained by assembling a magnetic core (21,22) and an electrical winding (23) comprises:
surface-mounting, on the lead frame (1), a magnetic core (21,22) of which an exterior is wound with the electrical winding (23).

12. The method according to any one of claims 9 to 11, wherein the electrical winding (23) is an aluminum strip, the one end (231) of the electrical winding (23) is electrically connected to the lead frame (1) in a bonding manner or an adhering manner, and the other end (232) of the electrical winding (23) is electrically connected to the semiconductor bare chip in a bonding manner or an adhering manner directly.

13. The method according to any one of claims 9 to 12, wherein the semiconductor bare chip is electrically connected to the lead frame (1) in an aluminum strip bonding manner or an adhering manner.

14. The method according to any one of claims 9 to 13, wherein when the electrical winding (23) has multiple turns, the turns are connected to each other in series or in parallel.

## Patentansprüche

1. Stromversorgungsmodul, das einen Anschlusskamm (1), einen integrierten Schaltkreis (5), passive Vorrichtungen und zwei Halbleiternacktchips (3, 4) umfasst, wobei:
mindestens eine Magnetvorrichtung der passiven Vorrichtungen eine diskrete Magnetvorrichtung ist, die durch einen Zusammenbau eines Magnetkerns (21, 22) und einer elektrischen Wicklung (23) erhalten wird; und
ein Ende (231) der elektrischen Wicklung (23) elektrisch mit dem Anschlusskamm (1) so verbunden ist, dass das eine Ende (231) der elektrischen Wicklung (23) mithilfe des Anschlusskamms (1) mit dem integrierten Schaltkreis (5) und den passiven Vorrichtungen mit der Ausnahme aller Magnetvorrichtungen elektrisch verbunden ist, **dadurch gekennzeichnet, dass**
eine Source eines der beiden Halbleiternacktchips mit einem Gate des anderen Halbleiternacktchips elektrisch verbunden ist, und das andere Ende der elektrischen Wicklung (23) direkt mit der Source des einen Halbleiternacktchips elektrisch verbunden ist, und das andere Ende (232) der elektrischen Wicklung (23) außerdem direkt mit dem Gate des anderen Halbleiternacktchips elektrisch verbunden ist.

2. Stromversorgungsmodul nach Anspruch 1, wobei der Magnetkern zwei halbe Magnetkerne (21, 22) umfasst, die in einer koppelnden Weise angeordnet sind, und wobei die elektrische Wicklung in dem Raum zwischen den gekoppelten halben Magnetkernen (21, 22) angeordnet ist.

3. Stromversorgungsmodul nach Anspruch 1, wobei die elektrische Wicklung (23) um eine Außenseite des Magnetkerns (21, 22) gewickelt ist.

4. Stromversorgungsmodul nach einem der Ansprüche 1 bis 3, wobei die elektrische Wicklung (23) ein Aluminiumband ist, wobei das eine Ende (231) der elektrischen Wicklung (23) in einer Bonding-Verbindung oder einer Haftverbindung mit dem Anschlusskamm (1) elektrisch verbunden ist, und wobei das andere Ende (232) der elektrischen Wicklung (23) in einer Bonding-Verbindung oder einer Haftverbindung direkt mit dem Halbleiternacktchip elektrisch verbunden ist.

5. Stromversorgungsmodul nach einem der Ansprüche 1 bis 4, wobei der Halbleiternacktchip mithilfe eines Aluminiumbands in einer Bonding-Verbindung oder einer Haftverbindung mit dem Anschlusskamm (1) elektrisch verbunden ist.

6. Stromversorgungsmodul nach einem der Ansprüche 1 bis 5, wobei die elektrische Wicklung (23) eine oder mehrere Windungen aufweist.

7. Stromversorgungsmodul nach einem der Ansprüche 1 bis 5, wobei, wenn die elektrische Wicklung (23) mehrere Windungen aufweist, die Windungen in Reihe oder parallel zueinander geschaltet sind.

8. Stromversorgungsmodul nach einem der Ansprüche 1 bis 7, wobei der Halbleiternacktchip eine vertikale Halbleitervorrichtung ist.

9. Verfahren zum Einhüllen eines Stromversorgungsmoduls, umfassend:
Oberflächenmontieren von zwei Halbleiternacktchips (3, 4), passiven Vorrichtungen, mit der Ausnahme einer Magnetvorrichtung, und eines integrierten Schaltkreises (5) auf einem Anschlusskamm (1) (Schritt 31);
Oberflächenmontieren auf dem Anschlusskamm (1) einer diskreten Magnetvorrichtung, die durch einen Zusammenbau eines Magnetkerns (21, 22) und einer elektrischen Wicklung (23) erhalten wird (Schritt 32);
elektrisches Verbinden einer Source eines der beiden Halbleiternacktchips mit einem Gate des anderen Halbleiternacktchips und elektrisches Verbinden eines Endes (231) der elektrischen Wicklung (23) mit dem Anschlusskamm (1), und elektrisches Verbinden des anderen Endes (232) der elektrischen Wicklung (23) direkt mit der Source des einen Halbleiternacktchips und außerdem elektrisches Verbinden des anderen Endes (232) der elektrischen Wicklung (23) direkt mit dem Gate des anderen Halbleiternacktchips (Schritt 33); und
nach dem ein Einhüllen in Kunststoff des Anschlusskamms ausgeführt wurde, auf dem die Komponenten oberflächenmontiert wurden, Schneiden des Anschlusskamms (1) um ein einzelnes Stromversorgungsmodul zu erhalten (Schritt 34).

10. Vorrichtung nach Anspruch 9, wobei das Oberflächenmontieren auf dem Anschlusskamm (1) einer diskreten Magnetvorrichtung, die durch einen Zusammenbau eines Magnetkerns (21, 22) und einer elektrischen Wicklung (23) erhalten wird, Folgendes umfasst:
Oberflächenmontieren eines halben Magnetkerns (21) auf dem Anschlusskamm (1) (Schritt 321);
Legen der elektrischen Wicklung (23) auf den halben Magnetkern (21) (Schritt 322); und
Anordnen des anderen halben Magnetkerns (22) in einer koppelnden Weise auf den halben Magnetkern (21), der auf den Anschlusskamm (1) oberflächenmontiert wurde (Schritt 323).

11. Verfahren nach Anspruch 9, wobei das Oberflächenmontieren auf dem Anschlusskamm (1) einer diskreten Magnetvorrichtung, die durch einen Zusammenbau eines Magnetkerns (21, 22) und einer elektrischen Wicklung (23) erhalten wird, Folgendes umfasst:
Oberflächenmontieren eines Magnetkerns (21, 22), um dessen Außenseite mit der elektrischen Wicklung (23) gewickelt ist, auf den Anschlusskamm (1).

12. Verfahren nach einem der Ansprüche 9 bis 11, wobei die elektrische Wicklung (23) ein Aluminiumband ist, wobei das eine Ende (231) der elektrischen Wicklung (23) in einer Bonding-Verbindung oder einer Haftverbindung mit dem Anschlusskamm (1) elektrisch verbunden ist, und wobei das andere Ende (232) der elektrischen Wicklung (23) in einer Bonding-Verbindung oder einer Haftverbindung direkt mit dem Halbleiternacktchip elektrisch verbunden ist.

13. Verfahren nach einem der Ansprüche 9 bis 12, wobei der Halbleiternacktchip mithilfe eines Aluminiumbands in einer Bonding-Verbindung oder einer Haftverbindung mit dem Anschlusskamm (1) elektrisch verbunden ist.

14. Verfahren nach einem der Ansprüche 9 bis 13, wobei die elektrische Wicklung (23) mehrere Windungen aufweist, wobei die Windungen in Reihe oder parallel zueinander geschaltet sind.

## Revendications

1. Module d'alimentation électrique, comportant une grille de connexion (1), un circuit intégré (5), des dispositifs passifs et deux puces nues semi-conductrices (3,4), dans lequel :
au moins un dispositif magnétique dans les dispositifs passifs est un dispositif magnétique distinct obtenu en assemblant un noyau magnétique (21, 22) et un enroulement électrique (23) ; et
une extrémité (231) de l'enroulement électrique (23) est reliée électriquement à la grille de connexion (1), de sorte que la première extrémité (231) de l'enroulement électrique (23) est reliée électriquement au circuit intégré (5) et aux dispositifs passifs, à l'exception de tous les dispositifs magnétiques, par l'intermédiaire de la grille de connexion (1), **caractérisé en ce que** :
une source d'une des deux puces nues semi-conductrices est reliée électriquement à une grille de l'autre puce nue semi-conductrice ; et l'autre extrémité de l'enroulement électrique (23) est reliée électriquement à la source de l'une des puces nues semi-conductrices directement, et l'autre extrémité (232) de l'enroulement électrique (23) est en outre reliée électriquement à la grille de l'autre puce nue semi-conductrice directement.

2. Module d'alimentation électrique selon la revendication 1, dans lequel le noyau magnétique comprend deux demi-noyaux magnétiques (21,22) disposés de manière accouplée, et l'enroulement électrique est disposé dans un espace entre les deux demi-noyaux magnétiques accouplés (21,22).

3. Module d'alimentation électrique selon la revendication 1, dans lequel l'enroulement électrique (23) est enroulé autour d'un extérieur du noyau magnétique (21,22).

4. Module d'alimentation électrique selon l'une quelconque des revendications 1 à 3, dans lequel l'enroulement électrique (23) est une bande d'aluminium, la première extrémité (231) de l'enroulement électrique (23) est reliée électriquement à la grille de connexion (1) d'une manière liée ou d'une manière adhérente, et l'autre extrémité (232) de l'enroulement électrique (23) est reliée électriquement à la puce nue semi-conductrice d'une manière liée ou d'une manière adhérente directement.

5. Module d'alimentation électrique selon l'une quelconque des revendications 1 à 4, dans lequel la puce nue semi-conductrice est reliée électriquement à la grille de connexion (1) d'une manière liée par bande d'aluminium ou d'une manière adhérente.

6. Module d'alimentation électrique selon l'une quelconque des revendications 1 à 5, dans lequel l'enroulement électrique (23) comporte une ou plusieurs spires.

7. Module d'alimentation électrique selon l'une quelconque des revendications 1 à 5, dans lequel, lorsque l'enroulement électrique (23) comporte de multiples spires, les spires sont reliées les unes aux autres en série ou en parallèle.

8. Module d'alimentation électrique selon l'une quelconque des revendications 1 à 7, dans lequel la puce nue semi-conductrice est un dispositif à semi-conducteur vertical.

9. Procédé de mise sous boîtier d'un module d'alimentation électrique, comprenant de :
monter en surface deux puces nues semi-conductrices (3,4), des dispositifs passifs, à l'exception d'un dispositif magnétique, et un circuit intégré (5) sur une grille de connexion (1) (étape 31) ;
monter en surface, sur la grille de connexion (1), un dispositif magnétique distinct obtenu en assemblant un noyau magnétique (21, 22) et un enroulement électrique (23) (étape 32) ;
relier électriquement une source de l'une des deux puces nues semi-conductrices à une grille de l'autre puce nue semi-conductrice et relier électriquement une extrémité (231) de l'enroulement électrique (23) à la grille de connexion (1), et relier électriquement l'autre extrémité (232) de l'enroulement électrique (23) à la source de l'une des puces nues semi-conductrices directement, et en outre, relier électriquement l'autre extrémité (232) de l'enroulement électrique (23) à la grille de l'autre puce nue semi-conductrice directement (étape 33) ; et
après que la mise sous boîtier plastique est réalisée sur la grille de connexion sur laquelle des composants sont montés en surface, découper la grille de connexion (1) pour obtenir un module d'alimentation électrique simple (étape 34).

10. Procédé selon la revendication 9, dans lequel le montage en surface, sur la grille de connexion (1), d'un dispositif magnétique distinct obtenu en assemblant un noyau magnétique (21, 22) et un enroulement électrique (23) comprend de :
monter en surface un demi-noyau magnétique (21) sur la grille de connexion (1) (étape 321) ;
déposer l'enroulement électrique (23) sur le demi-noyau magnétique (21) (étape 322) ; et
disposer un autre demi-noyau magnétique (22) d'une manière accouplée sur le demi-noyau magnétique (21) qui a été monté en surface sur la grille de connexion (1) (étape 323).

11. Procédé selon la revendication 9, dans lequel le montage en surface, sur la grille de connexion (1), d'un dispositif magnétique distinct obtenu en assemblant un noyau magnétique (21,22) et un enroulement électrique (23) comprend de :
monter en surface, sur la grille de connexion (1), un noyau magnétique (21,22), dont une partie extérieure est entourée par l'enroulement électrique (23).

12. Procédé selon l'une quelconque des revendications 9 à 11, dans lequel l'enroulement électrique (23) est une bande d'aluminium, la première extrémité (231) de l'enroulement électrique (23) est reliée électriquement à la grille de connexion (1) d'une manière liée ou d'une manière adhérente, et l'autre extrémité (232) de l'enroulement électrique (23) est reliée électriquement à la puce nue semi-conductrice d'une manière liée ou d'une manière adhérente directement.

13. Procédé selon l'une quelconque des revendications 9 à 12, dans lequel la puce nue semi-conductrice est reliée électriquement à la grille de connexion (1) d'une manière liée par bande d'aluminium ou d'une manière adhérente.

14. Procédé selon l'une quelconque des revendications 9 à 13, dans lequel, lorsque l'enroulement électrique (23) comporte de multiples spires, les spires sont reliées les unes aux autres en série ou en parallèle.
